(19)

Europäisches
Patentamt
European
Patent Office
Office européen
des brevets

(11) **EP 4 174 577 A1**

(12) **EUROPEAN PATENT APPLICATION**

(43) Date of publication:
**03.05.2023 Bulletin 2023/18**

(51) International Patent Classification (IPC):
***G03F 7/20*** (2006.01)

(21) Application number: **21205825.9**

(52) Cooperative Patent Classification (CPC):
**G03F 7/705; G03F 7/70625**

(22) Date of filing: **01.11.2021**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **BASTANI, Vahid
5500 AH Veldhoven (NL)**

• **KNOPS, Raoul, Maarten, Simon
5500 AH Eindhoven (NL)**
• **THEEUWES, Thomas
5500 AH Veldhoven (NL)**
• **URBANCZYK, Adam, Jan
5500 AH Veldhoven (NL)**
• **WILDENBERG, Jochem, Sebastiaan
5500 AH Veldhoven (NL)**
• **VAN WIJK, Robert Jan
5500 AH Veldhoven (NL)**

(74) Representative: **ASML Netherlands B.V.
Corporate Intellectual Property
P.O. Box 324
5500 AH Veldhoven (NL)**

(54) **METHOD OF DETERMINING A PERFORMANCE PARAMETER DISTRIBUTION**

(57)     Disclosed is a method of determining a performance parameter distribution and/or associated quantile function. The method comprises obtaining a quantile function prediction model operable to predict a quantile value for a substrate position and given quantile probability such that the predicted quantile values vary monotonically as a function of quantile probability and using the trained quantile function prediction model to predict quantile values for a plurality of different quantile probabilities for one or more substrate positions.

Fig. 3

**Description**

BACKGROUND

Field of the Invention

The present invention relates to a metrology apparatus and methods usable, for example, to perform metrology in the manufacture of devices by lithographic techniques. The invention further relates to such methods for monitoring stochastic effects in a lithographic process.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Today's patterning performance may be characterized by edge placement errors (EPE). The position error of the edge of a feature is determined by the features lateral position error (Overlay, pattern shift) and the error in size of the feature (CD error). Part of the feature dimension and position errors is very local and stochastic in nature; e.g., dependent on local placement errors relating to local overlay (LOVL), local CD uniformity (LCDU), Line Edge Roughness (LER) and line width roughness (LWR). All of these may be important contributors to the EPE performance.

Due to the local and stochastic nature of the EPE metric measuring EPE, and in particular across the wafer, is very metrology intensive. It would be desirable to reduce the metrology effort required for effective EPE monitoring.

SUMMARY OF THE INVENTION

The invention in a first aspect provides a method of determining a performance parameter distribution and/or associated quantile function, said performance parameter being associated a performance of a lithographic process for forming one or more structures on a substrate, the method comprising: obtaining a quantile function prediction model operable to predict a quantile value for a substrate position and given quantile probability such that the predicted quantile values vary monotonically as a function of quantile probability; and using said quantile function prediction model to predict quantile values for one or more quantile probabilities relating to one or more substrate positions.

The invention in a second aspect provides a method of representing parameter distribution data describing a variation of said parameter over a range of values as a Bernstein coefficient representation; the method comprising: determining an empirical cumulative distribution function from said parameter distribution data; transforming cumulative distribution function values from said empirical cumulative distribution function using an inverse cumulative distribution function of a normal distribution to obtain quantiles; mapping the quantiles to an interval [0,1], based on a chosen range for a fitting step; and fitting a Bernstein model using Bernstein basis polynomials to said quantiles to obtain a set of Bernstein coefficients, said fit being subject to at least one constraint to impose monotonicity.

The invention yet further provides a computer program product comprising machine-readable instructions for causing a processor to perform the method of the first or second aspect, and associated metrology apparatus and lithographic system.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;
Figure 2 depicts a lithographic cell or cluster in which an inspection apparatus according to the present invention may be used;
Figure 3 is a flowchart of a method for modeling a performance parameter distribution according to an embodiment of the invention;
Figure 4 illustrates the main features of a particular embodiment of a quantile function predictor model as may be used in the flow of Figure 3, according to an embodiment of the invention; and
Figure 5 illustrates a method for efficiently describing a histogram or performance parameter distribution usable in the method of Figure 3, and further usable in a general context.

DETAILED DESCRIPTION OF EXEMPLARY EMBODIMENTS

Before describing embodiments of the invention in detail, it is instructive to present an example environment in which embodiments of the present invention may be implemented.

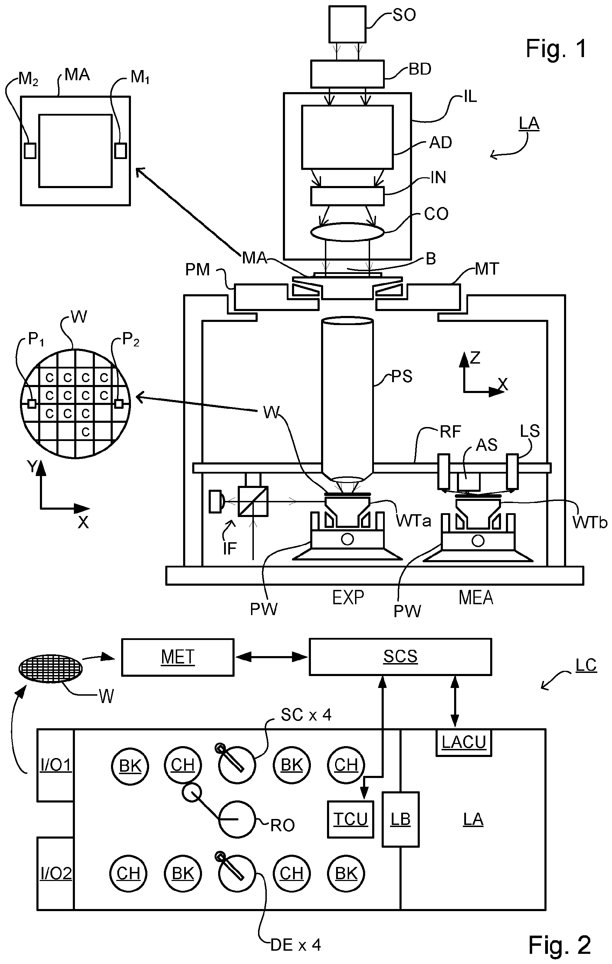

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

Patterning device (e.g., reticle/mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S. Patent Application Publication No. US 2010-0214550, which is incorporated herein in its entirety by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal positon errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991, which is incorporated herein in its entirety by reference.

Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses. M

Edge placement error EPE is a composed metric comprising contributions associated with overlay and local placement errors from product structures across multiple layers. To measure the local placement errors, metrology may be performed directly on the product structure. This can be done using a scanning electron microscope (SEM) such as an e-beam metrology apparatus for example. To obtain a dense EPE fingerprint across wafer, a very large metrology effort is presently required, comprising measurement of many feature instances at many locations on the wafer. More specifically, local effects are typically related to stochastic effects and hence require massive metrology to characterize the stochastic variation via e.g., a histogram. Global contributors (CDU / Overlay) are more related to more systematic effects as they relate to, for example, to processing tool fingerprints which are not stochastic in nature.

To illustrate this, one formulation of EPE is:

$$EPE = \frac{HR_{OPC}}{2} + \frac{3\sigma_{PBA}}{2} + \frac{6\sigma_{Local}}{\sqrt{2}} + \sqrt{(3\sigma_{overlay})^2 + (\frac{3\sigma_{CDU\_L}}{2})^2}$$

where $\sigma_{overlay}$, $\sigma_{PBA}$, $\sigma_{CDU\_L}$, $\sigma_{local}$ represent the standard deviation of respectively overlay, proximity bias average, line CDU and local errors due to resist and photon stochastics (which mainly affect line width roughness LWR); $HR_{OPC}$ is the half-range of the CD error due to optical proximity residuals.

For example, to characterize the local placement errors, histograms can be created by stacking contours of e-beam images of multiple features along a cut line of choice. For a full wafer /field /die fingerprint, a very large number of samples are needed which requires a very large measurement time. Measuring dense EPE distributions using an SEM tool is costly and time consuming. Each histogram may, for example, relate to a single field of view (or combined multiple fields of view) of a metrology tool (e.g., e-beam tool) and may comprise measurements from one or multiple wafers. Where the measurements relate to multiple wafers, the measurement data may be sorted according to wafer position, to obtain a histogram per wafer position.

EPE monitoring and control applications often rely on extreme value statistics to calculate metrics. This requires an accurate estimation of the tails of the local distribution (e.g., 4-6 times standard deviation). However, there is typically insufficient measurement points in the tails to enable an accurate characterization of the shape of the distribution. As a result, prediction of the local distribution often needs to extrapolate accurately to higher quantile values.

To address these issues, a generic machine learning framework for prediction of a performance parameter distribution (e.g., an EPE distribution as will be assumed in the example below or any other performance parameter distribution such as a CD distribution, feature placement distribution, overlay margin distribution, overlay distribution) in the form of a quantile predictor model is proposed. Such a quantile predictor model will be able to provide performance parameter distribution predictions with better estimation in the tail regions than present methods and without requiring the large measurement overhead of an actual performance parameter distribution characterization.

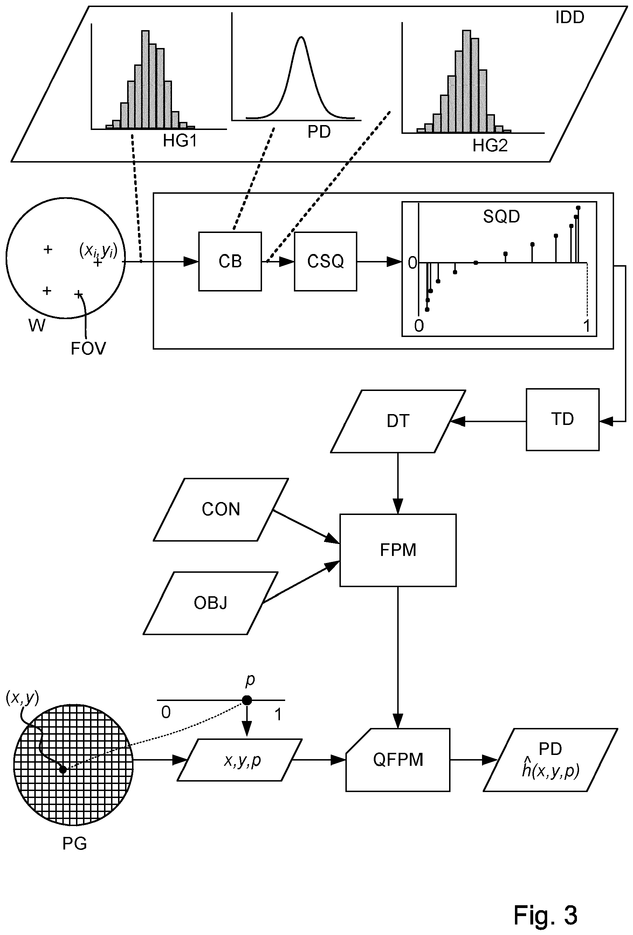

Figure 3 depicts an exemplary generic framework for training and using such a quantile predictor model. Input distribution data IDD or training distribution data is obtained. The input distribution data IDD data may, for example, comprise histogram data describing one or more measured histograms per point, where a point may relate to a particular point of field of view FOV measurement (e.g., using an SEM) at a location $(x, y)$ on a wafer W . The histogram data may comprise unprocessed histograms HG1. In an optional alternative, the unprocessed histograms HG1 may be processed or combined CB using prior knowledge of the distribution PD to obtain processed histogram data HG2. This optional step of combining the unprocessed histograms HG1 with a prior distribution PD will be described in more detail below. The prior knowledge may come from extensive setup phase measurements or physical knowledge.

The next step comprises calculating a set of sample quantile values CSQ for each of the histograms comprised within the processed histogram data HG2 or the unprocessed histogram data HG1 (depending on whether the processing step CB is performed). A set of sample quantile values for a histogram may comprise a set of data pairs $(p^n, h^n)$ where $p^n$ is the normalized cumulative sum of the number of occurrences for bin $n$ of the histogram and $h^n$ is the measured quantile value for the performance parameter for the bin n. The result of this step is sample quantile data SQD, represented as a cumulative plot of measured quantile value (y-axis) against quantile probability (x-axis).

A tabulate data step TD may be performed which organizes all the input distribution data or training data into a input distribution data table DT, comprising columns for: wafer location or measurement coordinates on the wafer ($x,$), quantile probability $p$ and measured quantile value $h^n$, as determined in the previous step.

A predictive model fit step FPM or training step fits a quantile function predictive model QFPM to the input distribution data represented in the input distribution data table DT, such that the fitted model can predict quantile values $\hat{h}$ from wafer coordinates $(x, y)$ and quantile probability p. This fit step is subject to one or more constraints CON. A necessary constraint is that $\hat{h}$ is monotonic with respect to $p$; i.e.: $\dfrac{\partial \hat{h}}{\partial p} \geq 0$ . Other optional constraints may improve the fit. A first such optional constraint may comprise a spatial smoothness constraint: the shape of $\hat{h}(p)$ is not expected to vary unboundedly with respect to $(x, y)$. A second such optional constraint may comprise a Gaussian constraint where the shape of $\hat{h}(p)$ is expected to be very similar to a Gaussian quantile function.

The fit may be effected using an objective function OBJ which minimizes a prediction error metric describing a magnitude of prediction error of a prediction from the quantile function predictive model QFPM. In a specific example, the prediction error metric may be the expected squared error of prediction $e^2 = (\hat{h} - h)^2$ (where $\hat{h}$ is the prediction and $h$ is the actual value). Should a compromise be required to fit the model, it is preferred to lower the prediction errors for high and low quantile probabilities rather than median quantile probabilities.

Once fitted, the quantile function predictive model QFPM can be used to make predictions (prediction data PD) $\hat{h}(x,y,p)$ on a dense spatial and quantile probability grid PG, based on an input of a wafer position or wafer coordinates $(x,y)$ and respective associated quantile probabilities $p$. In this way, the trained quantile function prediction model may be used to predict quantile functions for a plurality of different quantile probabilities for one or more wafer positions, thereby characterizing a predicted performance parameter distribution and/or associated quantile function for each of said one or more wafer positions.

As has been described, an initial processing step to process the input distribution data (measured histogram) with a prior distribution PD may be performed. This is optional and can be done prior to the model fitting step. It is expected that such a processing may result in a better fit for the tails of the distribution. In an embodiment, this can be performed using the Dirichlet-Multinomial conjugacy principle and Bayesian posterior update. The concept of the Dirichlet-Multinomial conjugacy principle is described in Wikipedia entry https://en.wikipedia.org/wiki/Dirichlet_distribution, which is hereby incorporated by reference.

In this context, a multinomial observation $(c_1, ... c_k)$ is the local histogram and the prior Dirichlet distribution parameters $(\alpha_1, ... \alpha_k)$ are obtained by binning the prior distribution (using measured histogram bins) and normalizing such that sum of $\alpha_1, ... \alpha_k$ reflects the level of confidence in the prior distribution compared to measured histogram. The sampled quantile values then be extracted from posterior Dirichlet distribution Dir(K, c+$\alpha$).

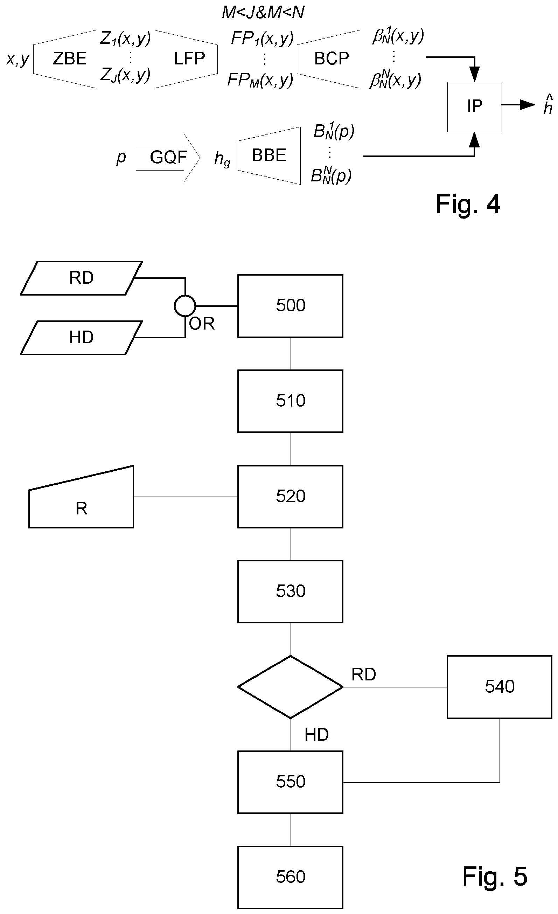

Figure 4 is a schematic illustration of the structure and model evaluation (prediction) formulation of a proposed realization of the quantile function predictive model QFPM according to an embodiment. The model is designed to be flexible while also supporting the aforementioned constraints. In the top row, Cartesian wafer coordinates $x, y$ may be subject to a Zernike basis expansion ZBE to obtain Zernike basis coefficients $Z_1(x,y) ... Z_j(x,y)$. This is optional and ensures spatial smoothness (i.e., to impose optional spatial smoothness constraint). A linear fingerprint predictor LFP is trained to predict fingerprint data (e.g., of the performance parameter) $FP_1(x,y) ... FP_M(x,y)$ where $M < J$, $M < N$.

Bernstein Coefficients predictor BCP is trained to predict Bernstein coefficients $\beta_N^1(x,y) ... \beta_N^N(x,y)$ . Fingerprint data may comprise a spatial representation of the performance parameter over the wafer. To respect the monotonicity constraint $\beta_N^1(x,y) \leq \beta_N^2(x,y) \leq \cdots \leq \beta_N^N(x,y)$ , this prediction may be performed via first prediction shape-restricted Bernstein polynomial coefficients for a given coordinate $(x, y)$ and polynomials evaluated on a desired quantile probability.

The mapping from spatial Zernike polynomial expansion to quantile Bernstein polynomial coefficients may be done via a low rank transformation.

In the bottom row, quantile probabilities $p$ associated with wafer coordinates $x, y$ may be transformed under Gaussian quantile functions GQF. This ensures that the predicted quantile functions are close to normal distribution (i.e., to impose optional Gaussian constraint). Such an approach may use a Gaussian distribution as a starting point and adding more parameters to the Gaussian distribution to capture deviation therefrom. Following this, a Bernstein basis expansion BBE (e.g., a low order Bernstein polynomial expansion) is performed on the quantile probabilities transformed under Gaussian quantile function $h_g$ to obtain Bernstein basis functions $B_N^1(p) ... B_N^N(p)$ .

Bernstein coefficients $\beta_N^1(x,y) ... \beta_N^N(x,y)$ and Bernstein basis functions $B_N^1(p) ... B_N^N(p)$ may be com-

bined, e.g., by determining their inner product IP, to obtain quantile value prediction $\hat{h}$. For example:

$\hat{h} = \sum_{i=1}^{N} \beta_N^i(x,y) B_N^i(p)$ where $\hat{h}$ is the inner product of the two vectors of size N: $\beta_N^i(x,y), B_N^i$.

To impose the monotonicity constraint, an additional structural restriction may be applied to ensure the predicted Bernstein coefficients are always monotonic (i.e., $\beta_N^1(x,y) \leq \beta_N^2(x,y) \leq \cdots \leq \beta_N^N(x,y)$). The simplest way to do this this is to predict the difference of coefficients $\Delta\beta_N^N = \beta_N^N - \beta_N^{N-1}$ together with boundary condition $\beta_N^1$ and apply positivity constraints on $\Delta\beta_N^i$.

In the fitting step, the part of the model to be fitted is the mapping of the Zernike basis expansion of the coordinate (*x*, *y*) to the set of coefficients of Bernstein polynomial basis (represented by LFP, BCP in Figure 4). The remainder of the model is fixed.

Two methods will be described for fitting the model illustrated in Figure 4 when using a weighted mean squared error (WMSE) objective function to perform the fit:

1. Stochastic Gradient Descend: this is achieved using differentiable programing methods where the model is iteratively evaluated for training data points, the gradient of every parameter of the model with respect to the objective function is calculated and the model updated accordingly until convergence. Theoretically, this method is an end-to-end optimization.

2. Stepwise greedy optimization: this method is suboptimal but fast. The steps are as follows:

a. For each FOV (*x*, *y*), fit a shape-restricted Bernstein polynomial using constrained Least Squares algorithm to obtain $\hat{\beta}_N^1(x,y) \leq \hat{\beta}_N^2(x,y) \leq \cdots \leq \hat{\beta}_N^N(x,y)$.

b. Calculate the delta Bernstein coefficients $\Delta\hat{\beta}_N^2(x,y) \leq \cdots \leq \Delta\hat{\beta}_N^N(x,y)$. Note that the delta coefficients are strictly positive values $\hat{\beta}_N^i(x,y) \in [0,+\infty)$.

c. Calculate the transformed delta coefficients to $v_N^i = r^{-1}(\hat{\beta}_N^i)$ where () is a bijective rectifying function (e.g. softplus). Note that $v_N^i \in (-\infty,+\infty)$. Also note that during prediction the parameters need to transform back to original Bernstein coefficients are $\hat{\beta}_N^i(x,y)$

d. Make a Partial Least Squares (PLS) fit from Zernike expansions $Z_1(x,y) \dots Z_J(x,y)$ for the set of parameters of the boundary coefficient $\hat{\beta}_N^1(x,y), v_N^2(x,y), \dots, v_N^N(x,y)$.

The above embodiment uses a Bernstein coefficient representation of the parameter of interest distribution (e.g., histogram) or associated quantile function. This has the advantage of being particularly space efficient. For example: if 1000 locations are measured on the wafer (not untypical), this results in 1000 histograms. Each of these histograms might have, for example, 500 bins. This results in $5 \times 10^5$ data points. The input data may actually comprise histograms for three properties (layer 1, layer 2 and their convolution), leading to $1.5 \times 10^6$ data points per wafer. Modeling of the data may be hosted on the applications platform and therefore may consume a lot of time.

As such, a method of representing each histogram in terms of Bernstein coefficients has been devised. The method is utilized in the above embodiment, and now will be described in more detail. It can be appreciated that this method can be implemented on its own for efficient representation of distribution data, as well as forming a part of one or more embodiments of the quantile function predictive modelling method already described.

Figure 5 is a flowchart describing a method of converting distribution data (e.g., from one measurement location) to a Bernstein coefficient representation and therefore can replace the distribution representation (e.g., histogram) in that location.

At step 500, raw data RD (e.g., one or more of: CD values, EPE values, feature placement values, overlay margin values, overlay values) or histogram data HG derived therefrom is obtained (e.g., histograms HD may be created optionally from the raw data RD), and their mean and standard deviation calculated.

At step 510, the empirical CDF (cumulative distribution function) is calculated. The CDF may comprise value pairs (*p*, *h*). This may correspond to the create sample quantile CSQ step in Figure 3.

At step 520 the CDF values (probability values) are transformed, using the inverse CDF of a standard normal distribution: $h' = \sqrt{2}\,\text{erf}^{-1}(2h - 1)$. This yields quantiles or theoretical quantiles, (the prime ' does not indicate a derivative, but a transformed variable). For fitting purposes, these values can be mapped to an interval [0,1]:

$$h'' = \frac{h'}{R} + 0.5\,y$$

, where $R$ is a chosen range for the fitting step. For example $R$=12 would indicate 12 times the standard deviation.

At step 540, the data points which correspond to empty bins may be removed (to prevent extra emphasis on these points), as may any 'inf' (infinity) values.

If raw data RD is used without creating histograms, a step of defining weights 540 may be performed. One option for a weight definition is $w$=1/$PDF$ where $PDF$ is the standard normal probability density function, which results in $w = \sqrt{2\pi}\,e^{\left(\hat{h}'^2/2\right)}$, using the theoretical quantiles $\hat{h}'$.

At step 550, a linear least squares fit is performed to fit a model to the theoretical quantiles using Bernstein basis polynomials and at least one constraint to guarantee monotonicity (as has been described). $\beta_N^i$ is the ith coefficient for a Bernstein model that comprises polynomials up to $N$-1 orders. The least squares fit may be weighted according to the weights determined in the previous step. In this way, an expected "density" of measured data points may be used to calculate the weights (e.g., where weight = 1/density) in order to prevent too great an emphasis on the center of the distribution.

At step 560, the distribution is fully characterized by the Bernstein coefficients $\beta_N^i$, the transformation function (i.e., the inverse CDF of a standard normal distribution: $h' = \sqrt{2}\,\text{erf}^{-1}(2h - 1)$)) and the chosen range $R$ for the theoretical quantiles.

In this way, it is often possible to use only 12 variables to describe the distribution (11 coefficients + range parameter $R$) instead of ~500 data points, while preserving the ability to describe skewness and kurtosis. - This method is also robust against metrology errors (outliers) and unphysical results. Convoluting two distributions can therefore be performed much more reliably. Extrapolation into the tails (beyond the available data points) is much more robust (less error-prone).

Further embodiments may be described by the following clauses:

1. A method of determining a performance parameter distribution and/or associated quantile function, said performance parameter being associated a performance of a lithographic process for forming one or more structures on a substrate, the method comprising:

obtaining a quantile function prediction model operable to predict a quantile value for a substrate position and given quantile probability such that the predicted quantile values vary monotonically as a function of quantile probability; and

using said quantile function prediction model to predict quantile values for one or more quantile probabilities relating to one or more substrate positions.

2. A method according to clause 1, wherein said quantile function prediction model is constrained to impose a spatial smoothness for said predicted quantile values across the substrate.

3. A method according to clause 2, wherein said spatial smoothness is such that a magnitude of a first and/or second order derivative of a function describing the predicted quantile values across the substrate is below a threshold value.

4. A method according to clause 2 or 3, wherein said quantile function prediction model is operable such that a spatial correlation of the predict quantile values are described by Zernike basis coefficients.

5. A method according to clause 4, comprising mapping from said spatial Zernike basis coefficients to Bernstein coefficients via a low rank transformation.

6. A method according to any preceding clause , comprising using said quantile function prediction model to predict fingerprint data describing spatial variation of said performance parameter over the substrate; and predict said quantile values from said fingerprint data.

7. A method according to clause 6, comprising using said quantile function prediction model to predict Bernstein coefficients from said fingerprint data; and predict said quantile values from said Bernstein coefficients.

8. A method according to clause 7, comprising performing a Bernstein basis expansion on said quantile probabilities to obtain Bernstein basis functions; and said step of predicting said quantile values from said Bernstein coefficients comprises predicting said quantile values from said Bernstein coefficients and said Bernstein basis functions.

9. A method according to clause 8, wherein said quantile probabilities are transformed under Gaussian quantile functions prior to performing said Bernstein basis expansion.

10. A method according to any of clauses 6 to 9, wherein said predicting step is performed via prediction shape-restricted Bernstein polynomial coefficients for a given substrate coordinate to impose said monotonicity constraint.

11. A method according to any preceding clause , wherein said quantile function prediction model is constrained to prefer quantile values which, in terms of quantile probability, define a substantially Gaussian quantile function.

12. A method according to any preceding clause , comprising a training or calibration step of training or calibrating said quantile function prediction model using input distribution data describing distributions of said performance parameter for a plurality of substrate locations.

13. A method according to clause 12, wherein said input distribution data is initially processed to combine the input distribution data with prior knowledge distribution data.

14. A method according to clause 12 or 13, wherein said training step comprises a fitting step for fitting said quantile function prediction model to said input distribution data.

15. A method according to clause 14, wherein said fitting step comprises minimizing an objective function which minimizes a prediction error metric.

16. A method according to clause 15, wherein said prediction error metric comprises a squared error of a prediction by said quantile function prediction model.

17. A method according to clause 14, 15 or 16, wherein said fitting step comprises performing a stochastic gradient descend method wherein the model is iteratively evaluated for input distribution data points, and the gradient of every parameter of the model with respect to the objective function is calculated and the model updated accordingly until convergence.

18. A method according to any of clauses 14 to 16, wherein said fitting step comprises performing a stepwise greedy optimization

19. A method according to any of clauses 14 to 18, wherein, in said fitting step, the fitting is weighted in favor of reducing prediction errors for high and low quantile probabilities in preference to reducing prediction errors for median quantile probabilities.

20. A method according to any preceding clause, wherein said performance parameter is associated with a position of said one or more structures on a substrate.

21. A method according to any preceding clause , wherein said performance parameter comprises critical dimension, edge placement error, feature placement, overlay margin or overlay.

22. A method according to any preceding clause , wherein said step of using said quantile function prediction model to predict quantile values characterizes a predicted performance parameter distribution and/or associated predicted quantile function for each of said one or more substrate positions.

23. A method of representing parameter distribution data describing a variation of said parameter over a range of values as a Bernstein coefficient representation; the method comprising:

determining an empirical cumulative distribution function from said parameter distribution data;
transforming cumulative distribution function values from said empirical cumulative distribution function using an inverse cumulative distribution function of a normal distribution to obtain quantiles;
mapping the quantiles to an interval [0,1], based on a chosen range for a fitting step; and
fitting a Bernstein model using Bernstein basis polynomials to said quantiles to obtain a set of Bernstein coefficients, said fit being subject to at least one constraint to impose monotonicity.

24. A method according to clause 23, comprising removing data points from the quantiles prior to the fitting step which correspond to empty bins and infinity values.

25. A method according to clause 23 or 24, wherein said parameter distribution data comprises one or more histograms.

26. A method according to clause 23 or 24, wherein said parameter distribution data comprises raw parameter distribution data; and the method comprises an additional step of defining weights from the quantiles.

27. A method according to any of clauses 23 to 26, wherein said fitting step comprise a linear least squares fit.

28. A method according to any of clauses 23 to 27, wherein the fitting step is such that the parameter distribution data is characterized by the Bernstein coefficients, chosen range and inverse cumulative distribution function.

29. A computer program comprising processor readable instructions which, when run on suitable processor controlled apparatus, cause the processor controlled apparatus to perform the method of any of clauses 1 to 28.

30. A computer program carrier comprising the computer program of clause 29.

31. A processing apparatus comprising:

a processor; and

a computer program carrier comprising the computer program of clause 30.

32. A metrology apparatus comprising the processing apparatus of clause 31.
33. A lithographic exposure apparatus comprising the processing apparatus of clause 31.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term target should not be construed to mean only dedicated targets formed for the specific purpose of metrology. The term target should be understood to encompass other structures, including product structures, which have properties suitable for metrology applications.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1.  A method of determining a performance parameter distribution and/or associated quantile function, said performance parameter being associated a performance of a lithographic process for forming one or more structures on a substrate, the method comprising:

    obtaining a quantile function prediction model operable to predict a quantile value for a substrate position and given quantile probability such that the predicted quantile values vary monotonically as a function of quantile probability; and
    using said quantile function prediction model to predict quantile values for one or more quantile probabilities relating to one or more substrate positions.

2.  A method as claimed in claim 1, wherein said quantile function prediction model is constrained to impose a spatial smoothness for said predicted quantile values across the substrate.

3.  A method as claimed in claim 2, wherein said quantile function prediction model is operable such that a spatial correlation of the predict quantile values are described by Zernike basis coefficients.

4.  A method as claimed in claim 3, comprising mapping from said spatial Zernike basis coefficients to Bernstein coefficients via a low rank transformation.

5.  A method as claimed in claim 1, comprising using said quantile function prediction model to predict fingerprint data describing spatial variation of said performance parameter over the substrate; and predict said quantile values from said fingerprint data.

6.  A method as claimed in claim 5, comprising using said quantile function prediction model to predict Bernstein coefficients from said fingerprint data; and predict said quantile values from said Bernstein coefficients.

7.  A method as claimed in claim 1, wherein said quantile function prediction model is constrained to prefer quantile values which, in terms of quantile probability, define a substantially Gaussian quantile function.

8.  A method as claimed in claim 1, comprising a training or calibration step of training or calibrating said quantile function prediction model using input distribution data describing distributions of said performance parameter for a plurality of substrate locations.

9. A method as claimed in claim 8, wherein said input distribution data is initially processed to combine the input distribution data with prior knowledge distribution data.

10. A method as claimed in claim 8, wherein said training step comprises a fitting step for fitting said quantile function prediction model to said input distribution data.

11. A method as claimed in claim 10, wherein said fitting step comprises minimizing an objective function which minimizes a prediction error metric.

12. A method as claimed in claim 10, wherein, in said fitting step, the fitting is weighted in favor of reducing prediction errors for high and low quantile probabilities in preference to reducing prediction errors for median quantile probabilities.

13. A method as claimed in claim 1, wherein said performance parameter comprises critical dimension, edge placement error, feature placement, overlay margin or overlay.

14. A method as claimed in claim 1, wherein said step of using said quantile function prediction model to predict quantile values characterizes a predicted performance parameter distribution and/or associated predicted quantile function for each of said one or more substrate positions.

15. A computer program comprising processor readable instructions which, when run on suitable processor controlled apparatus, cause the processor controlled apparatus to perform the method of claim 1.

Fig. 1

Fig. 2

Fig. 3

$$M < J \& M < N$$

$x,y$ → ZBE → $\begin{array}{c} Z_1(x,y) \\ \vdots \\ Z_J(x,y) \end{array}$ → LFP → $\begin{array}{c} FP_1(x,y) \\ \vdots \\ FP_M(x,y) \end{array}$ → BCP → $\begin{array}{c} \beta_N^1(x,y) \\ \vdots \\ \beta_N^N(x,y) \end{array}$ → IP → $\hat{h}$

$p$ → GQF → $h_g$ → BBE → $\begin{array}{c} B_N^1(p) \\ \vdots \\ B_N^N(p) \end{array}$

**Fig. 4**

RD, HD → OR → 500 → 510 → 520 ← R → 530 → ◇ — RD → 540 / HD → 550 ← 540 / → 560

**Fig. 5**

**EUROPEAN SEARCH REPORT**

Europäisches Patentamt
European Patent Office
Office européen des brevets

Application Number

EP 21 20 5825

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/210384 A1 (KLA TENCOR CORP [US]) 31 December 2014 (2014-12-31) | 1,7-15 | INV. G03F7/20 |
| Y | * paragraph [0017] – paragraph [0050] * * figure 1 * | 2-6 | |
| Y | US 2019/204180 A1 (MEDVEDYEVA MARIYA VYACHESLAVIVNA [NL] ET AL) 4 July 2019 (2019-07-04) | 2,3,5 | |
| A | * paragraph [0182] – paragraph [0199] * * figures 16-33 * | 1,15 | |
| Y | US 2021/286859 A1 (EUBANK STEPHEN [US] ET AL) 16 September 2021 (2021-09-16) | 4,6 | |
| A | * paragraph [0147] – paragraph [0154] * | 1,15 | |

TECHNICAL FIELDS SEARCHED (IPC)

G03F

The present search report has been drawn up for all claims

| Place of search | Date of completion of the search | Examiner |
|---|---|---|
| Munich | 13 April 2022 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 20 5825

This annex lists the patent family members relating to the patent documents cited in the above-mentioned European search report.
The members are as contained in the European Patent Office EDP file on
The European Patent Office is in no way liable for these particulars which are merely given for the purpose of information.

13-04-2022

| Patent document cited in search report | | | Publication date | Patent family member(s) | | | Publication date |
|---|---|---|---|---|---|---|---|
| WO 2014210384 | A1 | | 31-12-2014 | CN | 105474377 | A | 06-04-2016 |
| | | | | KR | 20160025585 | A | 08-03-2016 |
| | | | | TW | 201506659 | A | 16-02-2015 |
| | | | | US | 2015025846 | A1 | 22-01-2015 |
| | | | | WO | 2014210384 | A1 | 31-12-2014 |
| US 2019204180 | A1 | | 04-07-2019 | TW | 201940983 | A | 16-10-2019 |
| | | | | US | 2019204180 | A1 | 04-07-2019 |
| | | | | WO | 2019129468 | A1 | 04-07-2019 |
| US 2021286859 | A1 | | 16-09-2021 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A

- US 20130258310 A
- US 20130271740 A
- WO 2013178422 A1
- US 20100214550 A
- US 20070085991 A
- WO 2011081645 A
- US 2006016561 A
- US 2012008127 A